# EUROPÄISCHE PATENTSCHRIFT

(11) **EP 0 730 331 B1**
(45) Veröffentlichungstag und Bekanntmachung des Hinweises auf die Patenterteilung: **04.08.1999**
(21) Anmeldenummer: 96101874.4
(22) Anmeldetag: 09.02.1996
(51) Int. Cl.: H02H 7/122, H02M 7/538, H03K 17/082

(54) **Schaltungsanordnung zur Begrenzung von Schaltüberspannungen an Leistungshalbleiterschaltern**
Circuit for limiting switching overvoltages in power semiconductor switches
Circuit de limitation des surtensions lors de commutation pour commutateurs à semi-conducteur de puissance

(30) Priorität: 03.03.1995 DE 19507408
(43) Veröffentlichungstag der Anmeldung: 04.09.1996
(73) Patentinhaber: Kiepe Elektrik GmbH & Co. KG, 40599 Düsseldorf (DE)
(72) Erfinder: Seidl, Udo, D-47877 Willich (DE)
(74) Vertreter: Feder, Wolf-Dietrich, Dr. Dipl.-Phys.

(56) Entgegenhaltungen:
- EP-A- 0 272 514
- EP-A- 0 592 696
- WO-A-94/23497
- DE-A- 4 012 382
- TIHANYI J: "Protection of Power MOSFETs from Transient Overvoltages" SIEMENS-FORSHUNGS- UND ENTWICKLUNGSBERICHTE, Bd. 14, Nr. 2, 1985, Seiten 56-61, XP002047361

## Beschreibung

Die Erfindung betrifft eine Schaltungsanordnung zur Begrenzung von Schaltüberspannungen an Leistungshalbleiterschaltern, die über ihren Steuereingang ein- und ausschaltbar sind und insbesondere an in einem Zweig eines Stromrichters angeordneten Leistungshalbleiterschalter-Paaren.

Bei Schaltvorgängen in Stromrichtern verursachen Streuinduktivitäten Überspannungen, die je nach Höhe und Dauer zur Beschädigung der Leistungshalbleiterschalter führen können. Es ist bekannt, zum Schutz gegen solche Überspannungen zunächst die Streuinduktivitäten im Hauptstromkreis durch eine besonders günstige Ausbildung und Führung der Leitungen möglichst klein zu halten.

Es ist weiterhin bekannt, Spannungsbegrenzerschaltungen einzusetzen, die aus ohmschen Widerständen, Kondensatoren und Dioden aufgebaut sind (RCD-Spannungsbegrenzerschaltungen) und in an sich bekannter Weise nach Art einer Summenbeschaltung oder Einzelbeschaltung eingesetzt werden können. Beiden Schaltungsvarianten ist gemeinsam, daß im Prinzip der gesamte Laststrom vom abschaltenden Halbleiterschalter auf die Beschaltung wechseln soll. Dort wird die durch die Streuinduktivität verursachte Überspannung durch den Beschaltungskondensator abgefangen. Diese Beschaltungen sind grundsätzlich relativ aufwendig und haben nur eine bedingt ausreichende Wirksamkeit. Insbesondere ist nachteilig, daß das Beschaltungsnetzwerk auf den größtmöglichen Abschaltstrom dimensioniert werden muß. Dies bedeutet nicht nur einen höheren Aufwand an Bauteilen und damit höhere Kosten, sondern es entstehen insbesondere bei höheren Schaltfrequenzen relativ große Verlustleistungen, die über den Beschaltungswiderstand abgeführt werden. Dies bedingt einen hohen Kühlungsaufwand.

Es ist weiterhin bekanntgeworden, bei modernen schnellschaltenden Leistungshalbleiterschaltern, z.B. sogenannten IGBTs (Insulated-Gate-Bipolar-Transistor) oder MOSFETs Schaltüberspannungen nach einem anderen Verfahren ohne eine RCD-Beschaltung zu begrenzen. Dies wird in der Weise durchgeführt, daß der Leistungshalbleiterschalter beim Auftreten einer Überspannung sehr rasch wieder geringfügig in den leitenden Zustand gesteuert wird. Die Wirksamkeit dieses Verfahrens ist gut, da keine Kommutierung des Laststroms auf einen Beschaltungskreis erfolgen muß. Es ist auch möglich, Überströme und Kurzschlußströme in dieser Weise zu beherrschen. Der Schaltungsaufwand ist gering, allerdings werden erhöhte Anforderungen an die Ansteuerung gestellt.

So ist es beispielsweise bekannt, zwischen einem Hauptanschluß und dem Steueranschluß eines Leistungshalbleiterschalters eine Zener-Diode einzuschalten. Wird bei einem Schaltvorgang die verursachte Spannungsspitze größer als die Zener-Spannung, so fließt ein Strom über die Zener-Diode zum Steueranschluß des Leistungshalbleiterschalters und steuert diesen leitend. Diese Schaltungsanordnung besitzt aber den Nachteil, daß die Spannungsbegrenzung aufgrund von Herstellungstoleranzen und Temperaturkoeffizienten der Zener-Dioden nur ungenau möglich ist. Weiterhin ist die Verlustleistung der Zener-Diode so groß, daß normalerweise kein Dauerbetrieb möglich ist.

Es ist weiterhin bekannt, die Schaltüberspannungen an Leistungshalbleiterschaltern mit einer Schaltungsanordnung zu begrenzen, die einen Vergleicher mit nachgeschaltetem Analogverstärker mit Begrenzungskennlinie aufweist, der ausgangsseitig mit einem Steuereingang des zu schützenden Leistungshalbleiterschalters elektrisch leitend verbunden ist, wobei am Vergleicher eine Ist-Spannung und eine vorbestimmte Soll-Spannung des Hauptanschlusses dieses Leistungshalbleiterschalters anstehen. Als Vergleicher ist hierbei ein analoger Differenzverstärker vorgesehen.

Nachteilig an dieser bekannten Anordnung ist, daß sie relativ aufwendig ist und es Probleme bereitet, insbesondere den Differenzverstärker so auszulegen, daß er schnell genug reagiert, so daß auch bei hohen Schaltgeschwindigkeiten ein ausreichender Begrenzungseffekt erreicht wird.

Der Erfindung liegt die Aufgabe zugrunde, eine Schaltungsanordnung zur Begrenzung von Schaltüberspannungen an Leistungshalbleiterschaltern, die über ihren Steuereingang ein- und ausschaltbar sind, insbesondere an in einem Zweig eines Stromrichters angeordneten Leistungshalbleiterschalter-Paaren zu schaffen, bei der mit relativ geringem Schaltungsaufwand auch bei hohen Schaltgeschwindigkeiten eine sichere Begrenzung erzielt wird, insbesondere sollte es ermöglicht werden, einen beschaltungsfreien und kurzschlußfesten Stromrichter mit hoher Ausnutzung der Leistungshalbleiterschalter aufzubauen.

Die Lösung dieser Aufgabe geschieht erfindungsgemäß mit den Merkmalen aus dem Patentanspruch 1. Vorteilhafte Weiterbildungen der Erfindung sind in den Unteransprüchen beschrieben.

Der Grundgedanke der Erfindung besteht darin, dem Leistungshalbleiterschalter einen Steuerzweig parallel zu schalten, der einen ohmschen Spannungsteiler enthält und der so ausgelegt ist, daß nur beim Auftreten einer Überspannung durch den Spannungsteiler ein Strom fließt, so daß vom Abgriffspunkt des Spannungsteilers aus ein Steuersignal auf den Steuereingang des Leistungshalbleiterschalters gegeben wird, das die Steuerung des Leistungshalbleiterschalters in den leitenden Zustand bewirkt, bis die Überspannung unter einen vorgegebenen Wert abgesunken ist.

Der Vorteil der erfindungsgemäßen Schaltungsanordnung liegt darin, daß sie einfach aufgebaut ist und der Aufwand an zu verwendenden Bauteilen gering ist. So muß zwar der im Steuerzweig liegende Kondensator auf die volle Betriebsspannung ausgelegt sein, braucht aber nur eine im Vergleich zu Kondensatoren in anderen Beschaltungsnetzwerken relativ geringe Kapazität, beispielsweise im Bereich zwischen 1 und 10nF zu besitzen. Eine besonders vorteilhafte Ausführungsform der erfindungsgemäßen Schaltungsanordnung ist in Patentanspruch 2 beschrieben. Mit Hilfe dieses, einem Teil des Steuerzweigs parallel geschalteten zweiten Kondensators ist es möglich zu erreichen, daß die Schaltungsanordnung ganz besonders schnell anspricht und dadurch auch für sehr schnelle Schaltvorgänge besonders gut geeignet ist. Dies wird weiter unten anhand eines Ausführungsbeispiels näher erläutert. Dieser zweite Kondensator sollte ebenfalls auf die volle Betriebsspannung ausgelegt sein, besitzt aber eine sehr kleine Kapazität im Vergleich zum ersten Kondensator, die um den Faktor 1000 kleiner sein und beispielsweise im Bereich zwischen 1 und 10pF liegen kann.

Im folgenden wird anhand der beigefügten Zeichnungen ein Ausführungsbeispiel für eine Schaltungsanordnung nach der Erfindung näher erläutert.

In den Zeichnungen zeigen:
- Figur 1: ein Schaltbild einer Schaltungsanordnung zur Begrenzung von Schaltüberspannungen an einem in einem Zweig eines Stromrichters angeordneten Leistungshalbleiterschalter-Paar;
- Figur 2a: den zeitlichen Spannungsverlauf am Steuereingang vor dem Gatevorwiderstand eines Leistungshalbleiterschalters beim Ansprechen der Begrenzerschaltung in einer gegenüber Fig. 1 vereinfachten Ausführungsform;
- Figur 2b: den zeitlichen Spannungsverlauf am Haupteingang des Leistungshalbleiterschalters, der dem Spannungsverlauf nach Fig. 2a entspricht;
- Figur 3a: in einer Darstellung analog Fig. 2a den Spannungsverlauf am Steuereingang vor dem Gatevorwiderstand des Leistungshalbleiterschalters beim Ansprechen der Schaltungsanordnung nach Fig. 1;
- Figur 3b: in einer Darstellung analog Fig. 2b den entsprechenden Spannungsverlauf am Haupteingang des Leistungshalbleiterschalters.

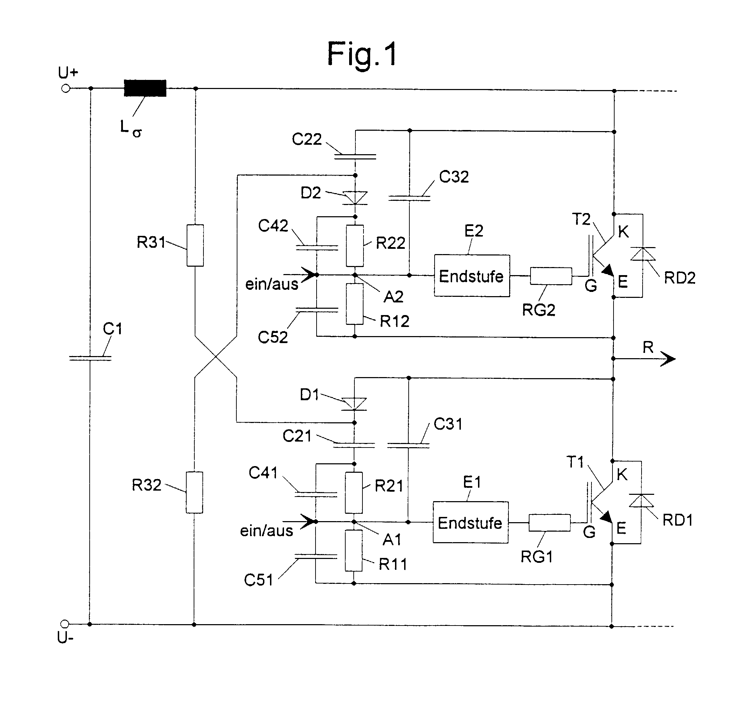

In Fig. 1 ist ein Teil eines Stromrichters dargestellt mit einem an eine Spannungsquelle U+, U- angeschlossenen Zwischenkreiskondensator C1, dem ein Zweig mit zwei in Serie geschalteten Leistungshalbleiterschaltern T1 und T2 parallelgeschaltet ist. Zwischen den beiden Leistungshalbleiterschaltern befindet sich ein Lastabgriff R. Als Leistungshalbleiterschalter können beispielsweise IGBT-Module dienen, mit jeweils einem Kollektor K, einem Emitter E und einem Gate G.

Gegenparallel zu den beiden Leistungstransitorhalbleiterschaltern T1 und T2 liegen in bekannter Weise Rücklaufdioden RD1 und RD2.

Die Ansteuerung der Module T1 und T2 erfolgt von einer nicht dargestellten Ansteuereinrichtung aus über Eingänge "ein/aus" sowie Endstufen E1, E2 und Gatevorwiderstände RG1 und RG2. Den Leistungshalbleiterschaltern T1 und T2 parallelgeschaltet ist jeweils ein Steuerzweig. Der dem Modul T1 zugeordnete Steuerzweig besitzt ausgehend vom Kollektor K an T1 in Serienschaltung eine Diode D1, einen Kondensator C21, einen ersten Spannungsteilerwiderstand R21 und einen zweiten Spannungsteilerwiderstand R11. Der Abgriffspunkt A1 des Spannungsteilers ist an den Eingang der Endstufe E1 der Ansteuerschaltung für das Modul T1 angeschlossen. Parallel zu den Widerständen R21 und R11 des Spannungsteilers liegen Kondensatoren C41 bzw. C51 zum kapazitiven Abgleich des Spannungsteilers. Weiterhin liegt parallel zu einem Teil des Steuerzweiges, und zwar zwischen dem Kollektor K des Moduls T1 und dem Abgriffspunkt A1 des Spannungsteilers ein weiterer Kondensator C31. Der Schaltungspunkt zwischen der Diode D1 und dem Kondensator C21 ist elektrisch über einen ohmschen Widerstand R31 mit dem positiven Ausgang U+ der Spannungsquelle verbunden.

Der dem Modul T2 zugeordnete Steuerzweig enthält in Serie, gerechnet vom Kollektor K aus einen Kondensator C22, eine Diode D2, einen ersten Spannungsteilerwiderstand R22 und einen zweiten Spannungsteilerwiderstand R12. Der Abgriff A2 zwischen den beiden Spannungsteilerwiderständen ist wiederum an den Eingang der Endstufe E2 der Ansteuerschaltung angeschlossen. Zum kapazitiven Abgleich der beiden Spannungsteilerwiderstände dienen parallelgeschaltete Kondensatoren C42, C52. Weiterhin ist einem Teil des Steuerzweigs, und zwar zwischen dem Kollektor K des Moduls T2 und dem Abgriffspunkt A2 ein weiterer Kondensator C32 eingeschaltet. Der Schaltungspunkt zwischen dem Kondensator C22 und der Diode D2 ist elektrisch über einen ohmschen Widerstand R32 mit dem negativen Ausgang U- der Spannungsquelle verbunden.

Die Streuinduktivität der Stromrichterschaltung ist durch die Induktivität Lσ symbolisiert. Diese Streuinduktivität ist verantwortlich für bei den Abschaltvorgängen der beiden Module T1 und T2 entstehenden Schaltüberspannungen.

Die Funktionsweise der in Fig. 1 dargestellten Schaltung wird zunächst ohne Berücksichtigung der zusätzlichen Kondensatoren C31 und C32 beschrieben.

Die Kondensatoren C21 und C22 sind auf den gleichen Spannungswert wie der Kondensator C1 aufgeladen. Entsteht an einem der Module T1 bzw. T2 eine Schaltüberspannung, so wird die Diode D1 bzw. D2 leitend. Es fließt ein Strom durch den Spannungsteiler R11, R21 bzw. R12, R22. Die am unteren Widerstand R11 bzw. R12 sich bei Stromfluß ergebende Spannung wird über die Endstufe E1 bzw. E2 dem Gate des Moduls T1 bzw. T2 zugeführt, das daraufhin von einem bestimmten Wert an in den leitenden Zustand gesteuert wird. Somit wird die Schaltüberspannung auf einen durch den Spannungsteiler einstellbaren Wert begrenzt. Wegen des nur sehr geringen durch die Anordnung fließenden Stromes wird der Kondensator C21 bzw. C22 während der Schaltüberspannung zusätzlich kaum aufgeladen. Im Anschluß an die Schaltüberspannung erfolgt eine Entladung des Kondensators über die Widerstände R31 bzw. R32 auf die Spannung des Zwischenkreiskondensators C1. Die gewünschte Schaltschwelle ist durch entsprechende Auslegung des Spannungsteilers R11, R21 bzw. R12, R22 einstellbar.

Ein sehr viel schnelleres Eingreifen der bisher beschriebenen Schaltungsanordnung kann erreicht werden durch die zusätzlichen Kondensatoren C31 und C32, die eine gegenüber C21 bzw. C22 kleine Kapazität besitzen. Ihre Kapazität kann beispielsweise etwa um den Faktor 1000 kleiner sein als die Kapazität der Kondensatoren C21 und C22. Durch diese zusätzlichen Kondensatoren C31 und C32 wird schon während der Anstiegszeit der Kollektor-Ermittler-Spannung am Leistungshalbleiterschalter die Steuerspannung bis dicht an den Schwellenwert herangeführt, so daß sogleich bei Beginn der Schaltüberspannung eine Reaktion der Begrenzerschaltung erfolgt. In der praktischen Ausbildung bietet es sich an, die beiden Kondensatoren C31 und C32 mit einer Kapazität <10pF aber hoher Spannungsfestigkeit in ein Platinenlayout mit einzubeziehen.

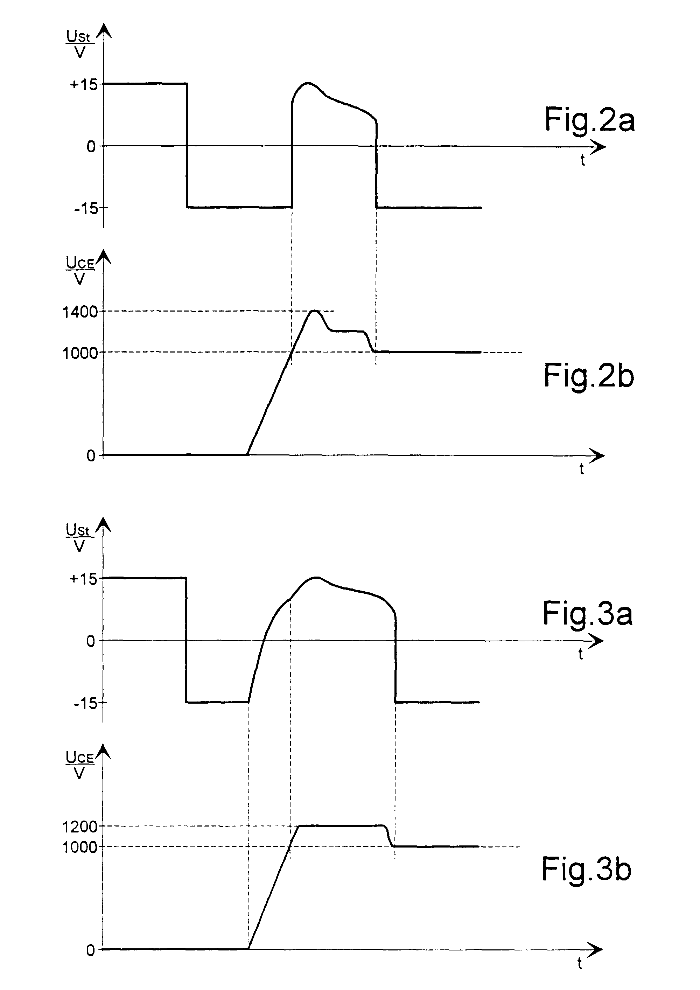

Aus den Fig. 2a bis 3b kann beispielhaft der Grad der Verbesserung entnommen werden, der durch Hinzuschaltung der Kondensatoren C31 und C32 erreichbar ist. Dabei beziehen sich die Fig. 2a und 2b auf eine Schaltungsanordnung analog Fig. 1, bei der diese beiden Kondensatoren nicht vorhanden sind, während die Fig. 3a und 3b genau der Schaltung nach Fig. 1 entsprechen.

In Fig. 2a ist zunächst der Verlauf der Steuerspannung UG am Gatevorwiderstand RG1 bzw. RG2 des Leistungshalbleiterschalters T1 bzw. T2 in Abhängigkeit von der Zeit t dargestellt. Zum Übergang vom leitenden in den gesperrten Zustand wechselt diese Steuerspannung vom Wert +15V auf -15V. In Fig. 2b ist der Verlauf der Schaltüberspannung dargestellt und zwar anhand der Kollektor-Ermittler-Spannung UCF. Die Fig. 3a und 3b zeigen in analoger Darstellung die beiden Spannungsverläufe bei der Schaltung nach Fig. 1, wenn die beiden zusätzlichen Kondensatoren C31 bzw. C32 eingesetzt sind. Ein Vergleich zeigt, daß bei Hinzunahme dieser beiden Kondensatoren eine deutlich schnellere Begrenzung der Schaltüberspannung möglich ist.

## Patentansprüche

1. Schaltungsanordnung zur Begrenzung von Schaltüberspannungen an Leistungshalbleiterschaltern, die über ihren Steuereingang ein- und ausschaltbar sind, insbesondere an in einem Zweig eines Stromrichters angeordneten Leistungshalbleiterschalter-Paaren (T1, T2) bestehend aus einem jeweils dem Leistungshalbleiterschalter (T1, T2) parallelgeschalteten Steuerzweig, der einen Spannungsteiler aus ohmschen Widerständen (R11, R21; R12, R22) enthält, dem ein erster Kondensator (C21; C22) und eine Diode (D1; D2) in Serie vorgeschaltet sind, wobei der Schaltungspunkt zwischen Kondensator (C21; C22) und Diode (D1; D2) über einen ohmschen Widerstand (R31; R32) mit einem auf einen Bezugspotential liegenden Punkt (U+; U-) der Gesamtschaltung verbunden ist und ein vorgegebener Abgriffspunkt (A1; A2) des Spannungsteilers mit dem Steuereingang (G) des Leistungshalbleiterschalters (T1, T2) verbunden ist.

2. Schaltungsanordnung nach Anspruch 1, bei der dem aus dem ersten Kondensator (C21; C22), der Diode (D1; D2) und dem von der Diode zum Abgriffspunkt (A1; A2) des Spannungsteilers führenden Teil (R21; R22) des Steuerzweigs ein zweiter Kondensator (C31; C32) parallelgeschaltet ist, dessen Kapazität wesentlich kleiner ist als die Kapazität des ersten Kondensators (C21; C22).

3. Schaltungsanordnung nach Anspruch 2, bei der die Kapazität des zweiten Kondensators (C31; C32) im wesentlichen um den Faktor 1000 kleiner ist als die Kapazität des ersten Kondensators (C21; C22).

4. Schaltungsanordnung nach einem der Ansprüche 1 bis 3, bei der der Abgriffspunkt (A1; A2) des Spannungsteilers mit dem Eingang der Endstufe (E1; E2) der Ansteuerschaltung des Leistungshalbleiterschalters (T1; T2) verbunden ist.

5. Schaltungsanordnung nach Anspruch 3, bei der die Kapazität des ersten Kondensators (C21; C22) im Bereich von 1-10nF und die Kapazität des zweiten Kondensators (C31; C32) im Bereich von 1-10pF liegt.

6. Schaltungsanordnung nach einem der Ansprüche 1 bis 5, bei der mindestens ein Teil des Spannungsteilers (R11-R21; R12-R22) durch einen parallel zu ihm liegenden dritten Kondensator (C41, C51; C42, C52) kapazitiv abgeglichen ist.

7. Schaltungsanordnung nach einem der Ansprüche 1 bis 6, mit zwei in einem Zweig eines Stromrichters in Serie zwischen die Pole einer Spannungsquelle (U+, U-) geschalteten Leistungshalbleiterschaltern (T1, T2) zwischen denen der Lastabgriff (R) angeordnet ist und bei der im Steuerzweig des mit dem negativen Pol (U-) der Spannungsquelle verbundenen Leistungshalbleiterschalters (T1) vom Lastabgriff (R) her gesehen die Diode (D1) vor dem ersten Kondensator (C21) angeordnet ist, an den sich der Spannungsteiler (R21-R11) anschließt und der Punkt zwischen Kondensator (C21) und Diode (D1) über den ohmschen Widerstand (R31) mit dem positiven Pol (U+) der Spannungsquelle verbunden ist, wohingegen im Steuerzweig des mit dem positiven Pol (U+) der Spannungsquelle verbundenen Leistungshalbleiterschalters (T2) vom positiven Pol her gesehen, der erste Kondensator (C22) vor der Diode (D2) angeordnet ist, an die sich der Spannungsteiler (R22-R12) anschließt und der Punkt zwischen ersten Kondensator (C22) und Diode (D2) über den ohmschen Widerstand (R32) mit dem negativen Pol (U-) der Spannungsquelle verbunden ist.

## Claims

1. Circuit arrangement for limiting switching surges at power semiconductor switches which can be switched on and off via their control input, particularly at pairs of power semiconductor switches (T1, T2) which are disposed in a branch of a current-converter and consist of a control branch which is connected in parallel with the power semiconductor switch (T1, T2) in each case and contains a voltage-divider which is made up of ohmic resistors (R11, R21; R12, R22) and in front of which a first capacitor (C21; C22) and a diode (D1; D2) are connected in series, wherein the point in the circuit between the capacitor (C21; C22) and the diode (D1; D2) is connected, via an ohmic resistor (R31; R32), to a point (U+; U-) in the overall circuit which carries a reference potential, and a predetermined tapping point (A1; A2) in the voltage-divider being connected to the control input (G) of the power semiconductor switch (T1, T2).

2. Circuit arrangement according to claim 1, in which a second capacitor (C31; C32) is connected in parallel with the first capacitor (C21; C22), the diode (D1; D2) and that part (R21; R22) of the control branch which leads from the diode to the tapping point (A1; A2) of the voltage-divider, the capacitance of the said second capacitor being substantially smaller than the capacitance of the first capacitor (C21; C22).

3. Circuit arrangement according to claim 2, in which the capacitance of the second capacitor (C31; C32) is smaller, substantially by a factor of 1000, than the capacitance of the first capacitor (C21; C22).

4. Circuit arrangement according to one of claims 1 to 3, in which the tapping point (A1; A2) of the voltage-divider is connected to the input of the final stage (E1; E2) of the activating circuit of the power semiconductor switch (T1; T2).

5. Circuit arrangement according to claim 3, in which the capacitance of the first capacitor (C21; C22) is in the region of 1-10nF and the capacitance of the second capacitor (C31; C32) is in the region of 1-10pF.

6. Circuit arrangement according to one of claims 1 to 5, in which at least one part of the voltage divider (R11-R21; R12-R22) is capacitively balanced by a third capacitor (C41, C51; C42, C52) which is in parallel with it.

7. Circuit arrangement according to one of claims 1 to 6, having two power semiconductor switches (T1, T2) which are connected, in a branch of a current-converter, in series between the poles of a voltage source (U+, U-) and between which the load tap (R) is disposed, and in which, in the control branch of that power semiconductor switch (T1) which is connected to the negative pole (U-) of the voltage source, the diode (D1) is disposed in front, viewed from the load tap (R), of the first capacitor (C21) to which the voltage-divider (R21-R11) is linked, and the point between the capacitor (C21) and the diode (D1) is connected, via the ohmic resistor (R31), to the positive pole (U+) of the voltage source, whereas in the control branch of that power semiconductor switch (T2) which is connected to the positive pole (U+) of the voltage source, the first capacitor (C22) is disposed in front, viewed from the positive pole, of the diode (D2) to which the voltage-divider (R22-R12) is linked, and the point between the first capacitor (C22) and the diode (D2) is connected, via the ohmic resistor (R32), to the negative pole (U-) of the voltage source.

## Revendications

1. Montage pour la limitation des surtensions de commutation sur des commutateurs de puissance à semi-conducteur qui peuvent être mis à l'état actif et à l'état inactif au moyen de leur entrée de commande, en particulier sur des paires de commutateurs de puissance à semi-conducteur (T1, T2) intercalées dans une branche d'un redresseur ce courant, composé d'une branche de commande connectée en parallèle avec le commutateur de puissance à semi-conducteur respectif (T1, T2), branche qui comprend elle-même un diviseur de tension composé de résistances ohmiques (R11, R21 ; R12, R22) en amont duquel sont connectés en série un premier condensateur (C21 ; C22) et une diode (D1 ; D2), le point de connexion entre le condensateur (C21 ; C22) et la diode (D1 ; D2) étant connecté à travers une résistance ohmique (R31 ; R32) à un point (U+ ; U-) de l'ensemble du montage qui se trouve à un potentiel de référence, et un point de prise prédéterminé (A1 ; A2) du diviseur de tension étant connecté à l'entrée de commande (G) du commutateur de puissance à semi-conducteur (T1, T2).

2. Montage selon la revendication 1, dans lequel un deuxième condensateur (C31 ; C32) dont la capacité est très inférieure à la capacité du premier condensateur (C21 ; C22) est connecté en parallèle avec la partie de la branche de commande composée du premier condensateur (C21 ; C22), de la diode (D1 ; D2) et de la partie (R21 ; R22) de cette branche qui conduit de la diode au point de prise (A1 ; A2) du diviseur de tension.

3. Montage selon la revendication 2, dans lequel la capacité du deuxième condensateur (C31 ; C32) est inférieure sensiblement d'un facteur 1000 à la capacité du premier condensateur (C21 ; C22).

4. Montage selon une des revendications 1 à 3, dans lequel le point de prise (A1 ; A2) du diviseur de tension est connecté à l'entrée de l'étage terminal (E1 ; E2) du circuit de commande du commutateur de puissance à semi-conducteur (T1 ; T2).

5. Montage selon la revendication 3, dans lequel la capacité du premier condensateur (C21 ; C22) se trouve dans l'intervalle de 1-10nF et la capacité du deuxième condensateur (C31 ; C32) dans l'intervalle de 1-10pF.

6. Montage selon une des revendications 1 à 5, dans lequel au moins une partie du diviseur de tension (R11-R21 ; R12-R22) est compensée capacitivement par un troisième condensateur (C41, C51 ; C42, C52) connecté en parallèle avec elle.

7. Montage selon une des revendications 1 à 6, comprenant deux commutateurs de puissance à semi-conducteur (T1, T2) connectés dans une branche d'un redresseur de courant, en série entre les pôles d'une source de tension (U+, U-), et entre lesquels est placée la prise de charge (R), et dans lequel la diode (D1) est disposée, dans la branche de commande du commutateur de puissance à semi-conducteur (T1) connecté au pôle négatif (U-) de la source de tension, en amont, vu de la prise de charge (R), du premier condensateur (C21) auquel se connecte le diviseur de tension (R21-R11), et le point entre le condensateur (C21) et la diode (D1) est connecté au pôle positif (U+) de la source de tension à travers la résistance ohmique (R31), tandis que, dans la branche de commande du commutateur de puissance à semi-conducteur (T2) qui est connecté au pôle positif (U+) de la source de tension, le premier condensateur (C22) est connecté en amont, vu du pôle positif, de la diode (D2) à laquelle se connecte le diviseur de tension (R22-R12), et le point entre le premier condensateur (C22) et la diode (D2) est connecté au pôle négatif (U-) de la source de tension à travers la résistance ohmique (R32).
